# EUROPEAN PATENT APPLICATION

(11) **EP 4 645 393 A1**
(43) Date of publication of application: **05.11.2025**
(21) Application number: 24759956.6
(22) Date of filing: 15.01.2024
(51) Int. Cl.: H01L 29/78, H01L 21/336, H01L 21/8238, H01L 27/092

(54) **SIC P-CHANNEL MOS FET AND SIC COMPLEMENTARY MOS DEVICE**

(30) Priority: 21.02.2023 JP 2023025123
(71) Applicant: Kyoto University, Kyoto-shi, Kyoto 606-8501 (JP)
(72) Inventor: KIMOTO, Tsunenobu, Kyoto-shi, Kyoto 606-8501 (JP); MIKAMI, Kyota, Kyoto-shi, Kyoto 606-8501 (JP)
(74) Representative: BRP Renaud & Partner mbB Rechtsanwälte Patentanwälte Steuerberater
(86) International application number: PCT/JP2024/000801
(87) International publication number: WO 2024/176649

(57) **Abstract**

A SiC p-channel MOSFET includes a SiC substrate 10 whose surface plane orientation is (0001), and a fin portion 100 protruding perpendicularly to the surface of the SiC substrate and made of SiC. The fin portion has a source region 30, a drain region 40, and a channel region 50 sandwiched between the source region and the drain region, a gate electrode 70 is formed through a gate oxidation film 60 over the side surfaces and upper surface of the channel region, and the side surface of the channel region 50 is a (1-100) plane.

## Description

### TECHNICAL FIELD

The present invention relates to a SiC p-channel MOSFET using a SiC substrate and a SiC complementary MOS device.

### BACKGROUND ART

In a MOS transistor (SiC MOSFET) using a SiC substrate, in a case where a SiO₂ film (gate oxidation film) is formed on the surface of the SiC substrate by thermal oxidation, the channel mobility of the SiC MOSFET is low because a defect density at an interface between the SiO₂ film and the SiC substrate is high.

Non-Patent Document 1 discloses, in order to enhance the channel mobility, a method in which after a SiO₂ film has been formed on the surface of a SiC substrate by thermal oxidation, thermal treatment is performed in NO (nitric oxide) gas atmosphere to nitride an interface between the SiO₂ film and the SiC substrate, thereby reducing a defect density at the interface between the SiO₂ film and the SiC substrate.

### CITATION LIST

### NON-PATENT DOCUMENT

NON-PATENT DOCUMENT 1: G.Y. Chung et al., IEEE Electron Device Lett., vol. 22, 176 (2001)

### SUMMARY OF THE INVENTION

### TECHNICAL PROBLEM

In a complementary MOS device including an n-channel MOSFET and a p-channel MOSFET, no current flows except upon switching, and a static power consumption is almost zero. Thus, the complementary MOS device is a basic device in a SiC integrated circuit.

However, in the SiC MOSFET, the channel mobility of the p-channel MOSFET is significantly lower than the channel mobility of the n-channel MOSFET. Thus, the characteristics of the p-channel MOSFET are a great cause for limiting the performance of the complementary MOS device, and there has been demanded a p-channel MOSFET with a great channel mobility.

An object of the present invention is to provide a SiC p-channel MOSFET with a great channel mobility.

### SOLUTION TO THE PROBLEM

A SiC p-channel MOSFET according to the present invention includes a SiC substrate whose surface plane orientation is (0001), and a fin portion protruding perpendicularly to a surface of the SiC substrate and made of SiC, the fin portion has a source region, a drain region, and a channel region sandwiched between the source region and the drain region, a gate electrode is formed through a gate oxidation film over the side surfaces and upper surface of the channel region, and the side surface of the channel region is a (1-100) plane.

### ADVANTAGES OF THE INVENTION

According to the present invention, the SiC p-channel MOSFET with the great channel mobility can be provided.

### BRIEF DESCRIPTION OF THE DRAWINGS

[FIG. 1] FIG. 1 is a view showing the structure of a prototype of a planar type p-channel MOSFET.
[FIG. 2] FIGS. 2A and 2B are graphs showing measurement results of the channel mobility of a p-channel MOSFET whose plane orientation of a channel surface is (1-100).
[FIG. 3] FIGS. 3A and 3B are graphs showing measurement results of the channel mobility of a p-channel MOSFET whose plane orientation of a channel surface is (11-20).
[FIG. 4] FIG. 4 is a graph showing the dependency of the channel mobility on a crystal plane.
[FIG. 5] FIG. 5 is a graph showing the dependency of the channel mobility on a channel direction.
[FIG. 6] FIG. 6 is a perspective view schematically showing the structure of a fin-type p-channel MOSFET in the present embodiment.
[FIG. 7] FIG. 7 is a perspective view in a state of a gate oxide film and a gate electrode being omitted from the p-channel MOSFET shown in FIG. 6.
[FIG. 8] FIG. 8 is a sectional view taken along VIII-VIII line in FIG. 6.
[FIG. 9] FIG. 9 is a sectional view taken along IX-IX line in FIG. 6.
[FIG. 10] FIG. 10 is a view showing the crystal orientation of a SiC crystal.
[FIG. 11] FIG. 11 is a view showing a SiC substrate formed with an orientation flat indicating a <1-100> direction.
[FIG. 12] FIGS. 12A to 12C are views for describing a method for manufacturing the SiC p-channel MOSFET in the present embodiment.
[FIG. 13] FIGS. 13A to 13C are views for describing the method for manufacturing the SiC p-channel MOSFET in the present embodiment.
[FIG. 14] FIG. 14 is a perspective view schematically showing the configuration of a SiC complementary MOS device in the present embodiment.
[FIG. 15] FIG. 15 is a perspective view in a state of a gate oxidation film and a gate electrode being omitted from the SiC complementary MOS device shown in FIG. 14.

### DESCRIPTION OF EMBODIMENTS

The inventor(s) et al. of the present application made a prototype of a planar type p-channel MOSFET using a SiC substrate whose surface plane orientations are (11-20) and (1-100), and the dependency of a channel mobility on a crystal plane was examined. In the planar type p-channel MOSFET, the plane orientation of the surface of the SiC substrate is the plane orientation of a channel region. Note that crystallographically, the negative index of a lattice plane is expressed by placing "-" (bar) above a number, but in the present specification, is expressed by placing "-" (minus sign) in front of a number for the sake of convenience in description.

The planar type p-channel MOSFET was produced by the following method.

An n-type region 210 having an n-type impurity (nitrogen) concentration of 5 × 10¹⁵ to 8 × 10¹⁷ cm⁻³ was formed on an n-type SiC substrate 200, and thereafter, a p-type source region 220 and a drain region 230 were formed in the surface of the n-type region 210. A portion between the source region 220 and the drain region 230 is a channel region 240. Thereafter, a gate oxide film 250 having a film thickness of 40 nm was formed on the surfaces of the source region 220, the drain region 230, and the channel region 240 by thermal oxidation, and thereafter, thermal treatment was performed in NO (nitric oxide) gas atmosphere. Finally, a gate electrode 260, a source electrode 270, and a drain electrode 280 were formed. Note that a channel length was 100 µm, and a channel width was 50 µm.

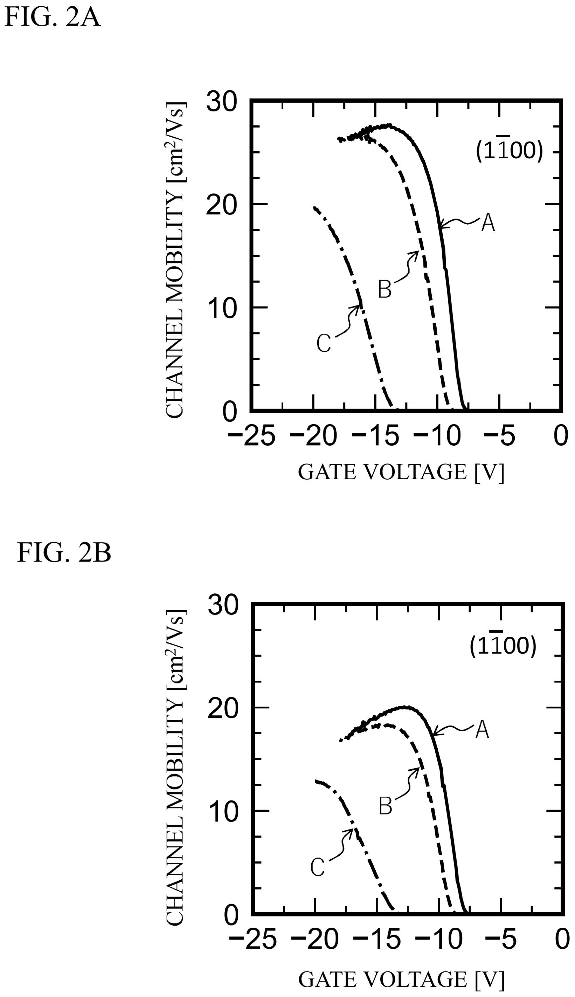

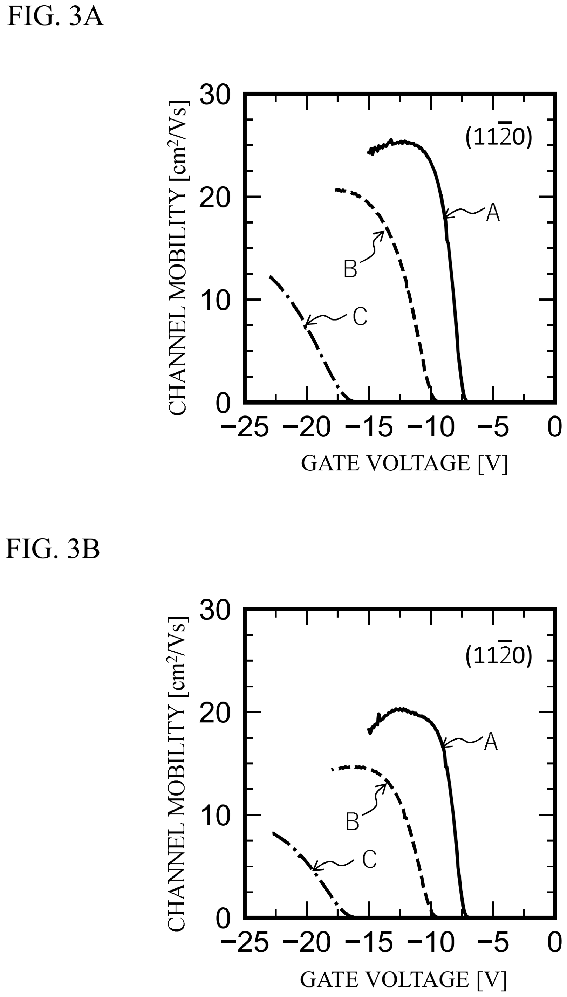

FIGS. 2A and 2B and FIGS. 3A and 3B are graphs showing measurement results of the channel mobility (drain voltage: -0.1 V) of the produced p-channel MOSFET, FIGS. 2A and 2B showing a case where the plane orientation of the channel surface is (1-100) and FIGS. 3A and 3B showing a case where the plane orientation of the channel surface is (11-20). Moreover, FIGS. 2A and 3A show a case where a channel direction (direction of drain current) is perpendicular to a c-axis <0001> direction, and FIGS. 2B and 3B show a case where the channel direction is parallel with the c-axis <0001> direction. Further, in FIGS. 2A and 2B, graphs indicated by arrows A, B, C each show cases where the impurity concentration (channel concentration) of the channel region 240 is 1 × 10¹⁶ cm⁻³, 5 × 10¹⁶ cm⁻³, and 4 × 10¹⁷ cm⁻³. In addition, in FIGS. 3A and 3B, graphs indicated by arrows A, B, C each show cases where the impurity concentration (channel concentration) of the channel region 240 is 5 × 10¹⁵ cm⁻³, 8 × 10¹⁶ cm⁻³, and 8 × 10¹⁷ cm⁻³.

### <Dependency of Channel Mobility on Crystal Plane >

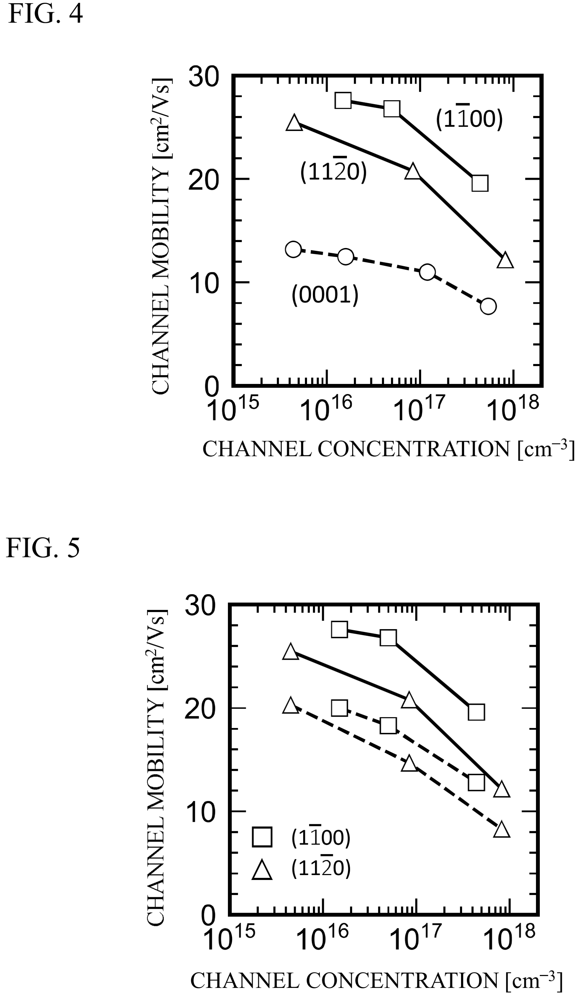

FIG. 4 is a graph showing the dependency of the channel mobility on the crystal plane based on the measurement results shown in FIGS. 2A and 3A. The horizontal axis represents the channel concentration, and the vertical axis represents the maximum value of the channel mobility when the channel direction is perpendicular to the c-axis. A graph indicated by rectangles shows a case where the plane orientation of the channel surface is (1-100), and a graph indicated by triangles shows a case where the plane orientation of the channel surface is (11-20). Note that for comparison, a graph indicated by circles shows a case where the plane orientation of the channel surface is (0001).

### <Dependency of Channel Mobility on Channel Direction >

FIG. 5 is a graph showing the dependency of the channel mobility on the channel direction based on the measurement results shown in FIGS. 2A and 2B and FIGS. 3A and 3B. The horizontal axis represents the channel concentration, and the vertical axis represents the maximum value of the channel mobility. A graph indicated by rectangles shows a case where the plane orientation of the channel surface is (1-100), and a graph indicated by triangles shows a case where the plane orientation of the channel surface is (11-20). Moreover, a graph indicated by a solid line shows a case where the channel direction is perpendicular to the c-axis, and a graph indicated by a dashed line shows a case where the channel direction is parallel with the c-axis.

FIG. 4 shows that the channel mobility is greater in the case where the plane orientation of the channel surface is (1-100) than in the case of (11-20). Moreover, FIG. 5 shows that even in the case of the same plane orientation of the channel surface, the channel mobility is greater in the case where the channel direction is perpendicular to the c-axis than in the case where the channel direction is parallel with the c-axis.

That is, when the p-channel MOSFET whose plane orientation of the channel surface is (1-100) and whose channel direction is perpendicular to the c-axis can be produced, the p-channel MOSFET with a great channel mobility can be provided.

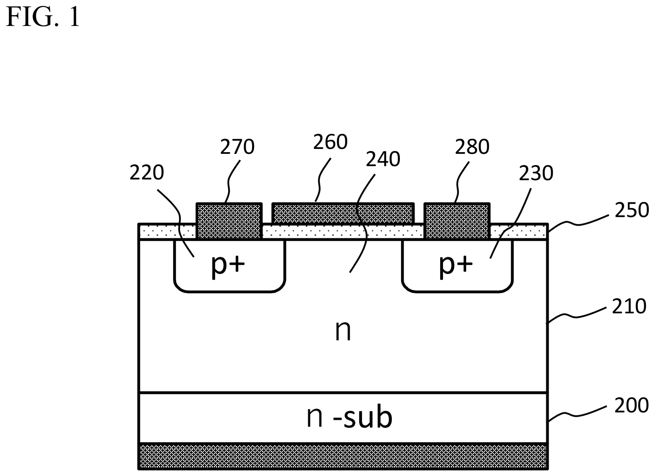

The measurement results described above are obtained for the planar type MOSFET shown in FIG. 1, which is a MOSFET produced using a SiC substrate whose surface plane orientation is the same as the plane orientation of a channel surface. However, due to easy aperture expansion, easy high-quality crystal growth, and the like, as a SiC substrate used in a mass production process, a SiC substrate whose surface plane orientation is (0001) is used in most cases. Thus, as long as the planar type MOSFET is produced using the SiC substrate whose surface plane orientation is (0001), the p-channel MOSFET whose plane orientation of the channel surface is (1-100) and whose channel direction is perpendicular to the c-axis cannot be provided.

The present invention provides, using a SiC substrate whose surface plane orientation is (0001), a fin-type SiC p-channel MOSFET whose plane orientation of a channel surface is (1-100) and whose channel direction is perpendicular to the c-axis.

### <Structure of Fin-Type p-Channel MOSFET>

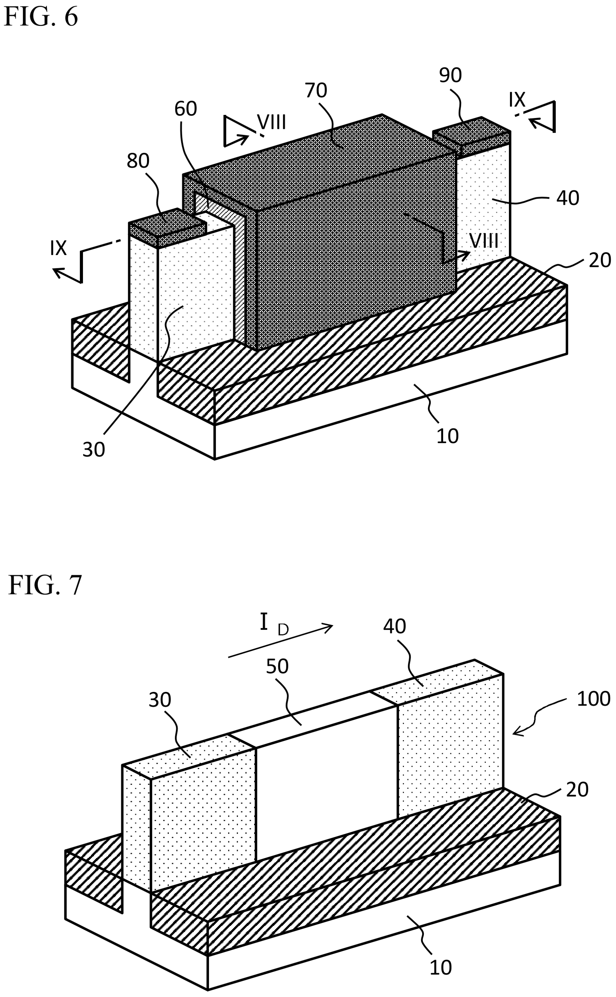

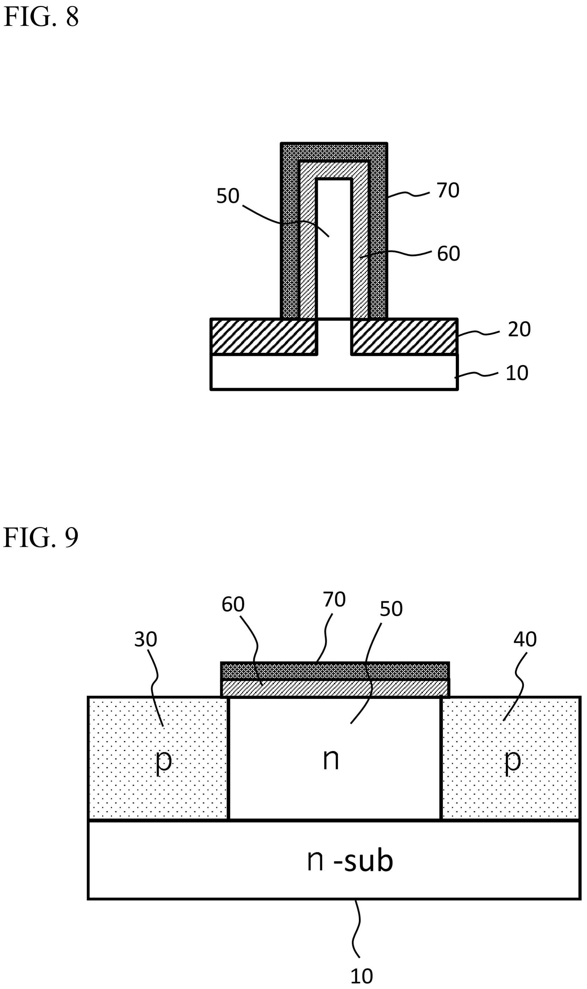

FIG. 6 is a perspective view schematically showing the structure of the fin-type p-channel MOSFET in the present embodiment. FIG. 7 is a perspective view in a state of a gate oxide film and a gate electrode being omitted from the p-channel MOSFET shown in FIG. 6. FIG. 8 is a sectional view taken along VIII-VIII line in FIG. 6. FIG. 9 is a sectional view taken along IX-IX line in FIG. 6.

As shown in FIGS. 6 to 9, the p-channel MOSFET in the present embodiment includes an n-type SiC substrate 10 whose surface plane orientation is (0001), and a fin portion fin portion 100 protruding perpendicularly to the surface of the SiC substrate 10 and made of SiC. The fin portion 100 has a p-type source region 30, a p-type drain region 40, and an n-type channel region 50 sandwiched between the source region 30 and the drain region 40. A field oxidation film 20 is formed on the surface of the SiC substrate 10, and the fin portion 100 is formed so as to penetrate the field oxidation film 20 from the SiC substrate 10. A gate electrode 70 is formed through a gate oxidation film 60 over the side surfaces and upper surface of the channel region 50. A source electrode 80 and a drain electrode 90 are formed on the upper surfaces of the source region 30 and the drain region 40.

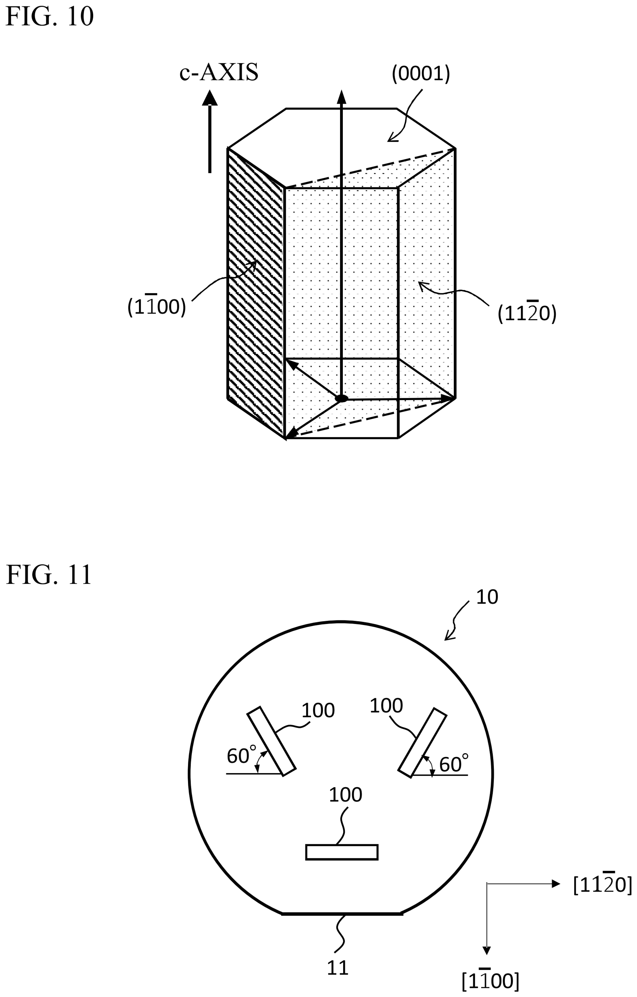

FIG. 10 is a view showing the crystal orientation of a SiC crystal. As shown in FIG. 10, a (1-100) plane is a plane perpendicular to a (0001) plane. Thus, the fin portion 100 is formed so as to protrude perpendicularly to the surface of the SiC substrate 10, and therefore, the side surface (channel surface) of the channel region 50 is the (1-100) plane. Moreover, as shown in FIG. 7, the direction of drain current I_{D} is parallel with the surface of the SiC substrate 10, and therefore, a channel direction is perpendicular to the c-axis.

Thus, in the SiC p-channel MOSFET having the structure shown in FIG. 6, the plane orientation of the channel surface is (1-100), and the channel direction is perpendicular to the c-axis. Consequently, the p-channel MOSFET with a great channel mobility can be provided.

Note that as shown in FIG. 10, a (11-20) plane is also perpendicular to the (0001) plane, and therefore, the fin portion 100 needs to be formed on the surface of the SiC substrate 10 such that the side surface of the channel region 50 is the (1-100) plane.

As a specific method, for example, as shown in FIG. 11, a commercially-available SiC (0001) substrate (wafer) 10 is generally formed with an orientation flat 11 indicating a <1-100> direction. Thus, the fin portion 100 is formed so as to extend in a direction parallel with the orientation flat 11, so that the side surface (channel surface) of the channel region 50 can be the (1-100) plane. Note that instead of the orientation flat 11, a notch indicating the <1-100> direction may be formed.

Note that in the SiC crystal, a (01-10) plane and a (10-10) plane crossing the (1-100) plane at an angle of 60 degrees are also equivalent to the (1-100) plane, and therefore, as shown in FIG. 11, the fin portion 100 may be formed so as to extend in a direction crossing the orientation flat 11 at an angle of 60 degrees.

When a channel surface (1-100) is described in the present specification, such a surface includes the (01-10) plane and the (10-10) plane equivalent to the (1-100) plane.

### <Method for Manufacturing SiC p-Channel MOSFET>

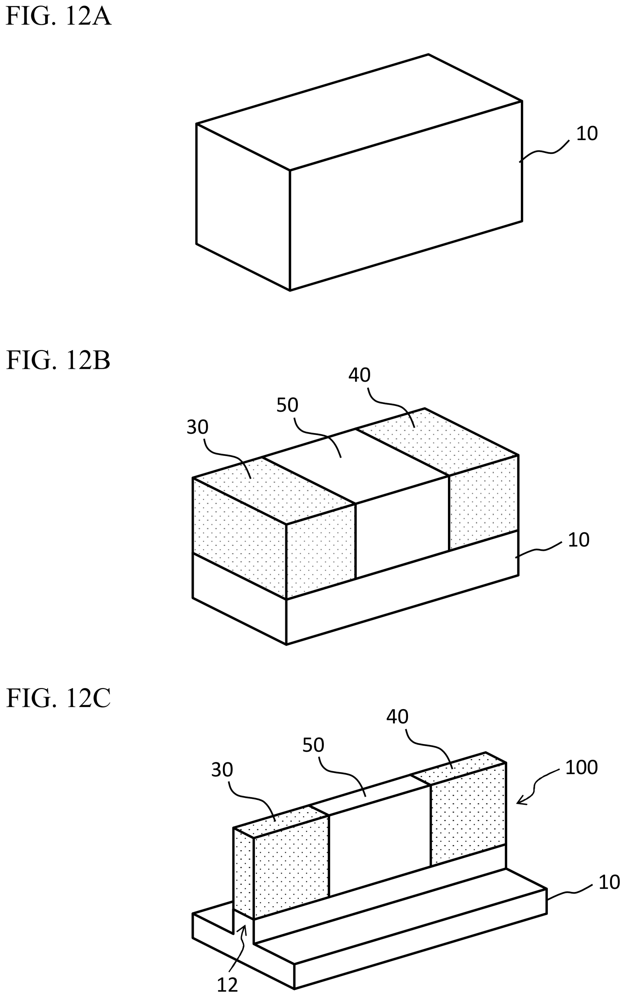

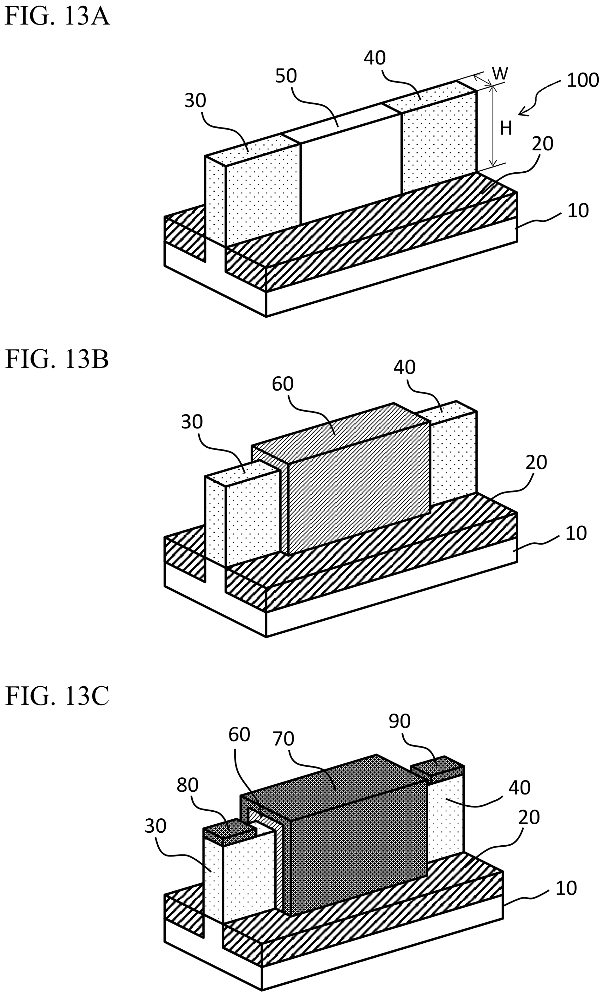

A method for manufacturing the SiC p-channel MOSFET in the present embodiment will be described with reference to FIGS. 12A to 12C and FIGS. 13A to 13C. Note that the method for manufacturing the SiC p-channel MOSFET is not limited thereto.

First, as shown in FIG. 12A, the n-type SiC substrate 10 whose surface plane orientation is (0001) is prepared. As shown in FIG. 11, a substrate in the form of a wafer can be used as the SiC substrate 10.

Next, as shown in FIG. 12B, a p-type impurity (aluminum or boron) is selectively ion-implanted into the surface of the SiC substrate 10 by a photolithography method, and the p-type source region 30 and drain region 40 are formed. Note that as necessary, an n-type impurity (nitrogen or phosphorus) may also be selectively ion-implanted into the n-type channel region 50 sandwiched between the source region 30 and the drain region 40.

Next, as shown in FIG. 12C, the source region 30, the channel region 50, and the drain region 40 are selectively etched by the photolithography method, and the fin portion 100 is formed. At this time, the surface of the SiC substrate 10 is simultaneously etched such that part 12 of the SiC substrate 10 remains immediately below the fin portion 100. As the etching for forming the fin portion 100, reactive ion etching with plasma is generally used.

Note that the upper surface of the fin portion 100 is also a channel surface, but does not contribute to improvement in the channel mobility because the plane orientation thereof is

(0001). Thus, when the height of the side surface of the fin portion 100 is H and the width of the upper surface is W as shown in FIG. 13A, an aspect ratio (H/W) is preferably 2 or more. When the aspect ratio is less than 2, the contribution of the channel surface, which is the upper surface, of the fin portion 100 to the channel mobility relatively increases, and the effect of the present invention lowers. Note that although there is no strict limitation on the width of the fin portion 100, a width of about 0.05 to 2 µm is appropriate.

Next, as shown in FIG. 13A, the field oxidation film 20 is selectively formed on the surface of the SiC substrate 10, except for the fin portion 100. Specifically, a SiO₂ film is deposited over the entire surface by a chemical vapor deposition method, and thereafter, the SiO₂ film on the upper surface and side surfaces of the fin portion 100 is removed using the photolithography method.

Next, as shown in FIG. 13B, the gate oxidation film 60 is selectively formed over the side surfaces and upper surface of the channel region. Specifically, a thermal oxidation film is formed on the side surfaces and upper surface of the fin portion 100, and thereafter, is selectively etched by the photolithography method. In this manner, the gate oxidation film 60 can be formed. The thermal oxidation is generally performed at a temperature of about 1150 to 1300°C to form an oxidation film with a thickness of about 5 to 80 nm. Instead of the thermal oxidation, the oxidation film may be formed by a deposition method.

Finally, as shown in FIG. 13C, the gate electrode 70 is formed, by the photolithography method, so as to cover the gate oxidation film 60, and the source electrode 80 and the drain electrode 90 are formed on the upper surfaces of the source region 30 and the drain region 40. In this manner, the SiC p-channel MOSFET shown in FIG. 6 is completed. Low-resistance polycrystal Si is generally used for the gate electrode, but metal such as Mo or W may be used.

### <SiC Complementary MOS Device>

A high channel mobility is obtained from the SiC p-channel MOSFET in the present embodiment, and therefore, the SiC p-channel MOSFET and a SiC n-channel MOSFET having a similar structure form a SiC complementary MOS device so that the SiC complementary MOS device with a great mutual conductance and a high switching speed can be provided.

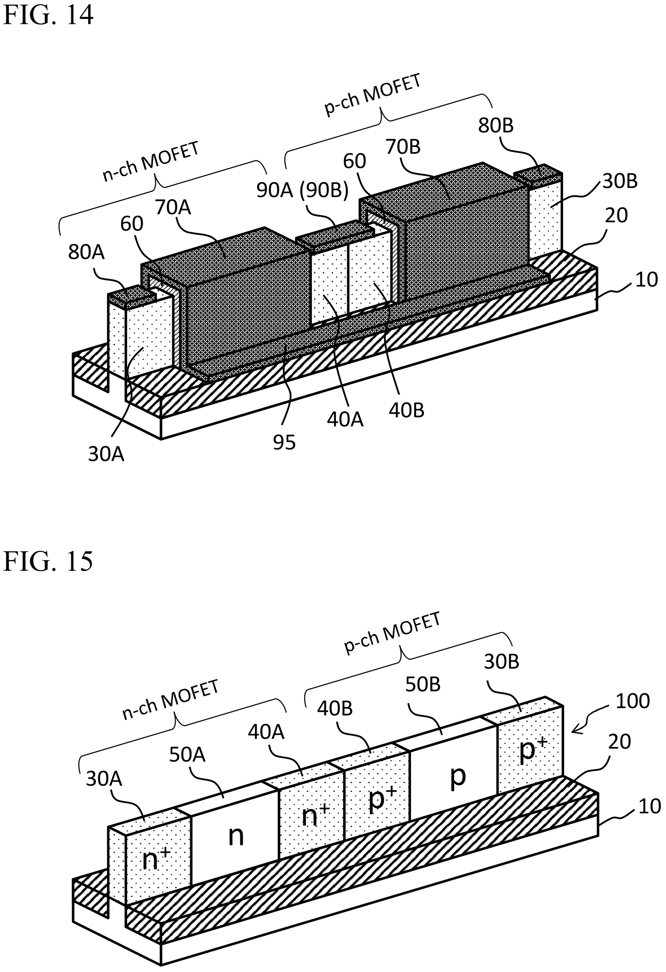

FIG. 14 is a perspective view schematically showing the configuration of the SiC complementary MOS device in the present embodiment. FIG. 15 is a perspective view in a state of the gate oxidation film and the gate electrode being omitted from the SiC complementary MOS device shown in FIG. 14.

As shown in FIG. 14, the SiC n-channel MOSFET and the SiC p-channel MOSFET are formed on the SiC substrate 10 whose surface plane orientation is (0001). As shown in FIG. 15, the fin portion 100 protruding perpendicularly to the surface of the SiC substrate 10 and made of SiC is provided, and in the fin portion 100, a source region 30A, a channel region 50A, and a drain region 40A of the n-channel MOSFET and a source region 30B, a channel region 50B, and a drain region 40B of the p-channel MOSFET are formed.

In each of the n-channel MOSFET and the p-channel MOSFET, the plane orientation of the channel surface is (1-100), and the channel direction is perpendicular to the c-axis.

In each of the n-channel MOSFET and the p-channel MOSFET, a gate electrode 70A, 70B is formed through the gate oxidation film 60 over the side surfaces and upper surface of the channel region 50A, 50B. Note that the gate electrodes 70A, 70B are connected through a wiring 95 formed in the field oxidation film 20. Moreover, on the upper surfaces of the source region 30A, the drain region 40A, the source region 30B, and the drain region 40B, a source electrode 80A, a drain electrode 90A, a source electrode 80B, and a drain electrode 90B are formed. Note that the drain electrodes 90A, 90B are a common electrode.

The present disclosure has been described above with reference to the preferred embodiment, but such description is not limited and various modifications can be made.

### DESCRIPTION OF REFERENCE CHARACTERS

- 10: SiC substrate
- 11: Orientation flat
- 20: Field oxidation film
- 30, 30A, 30B: Source region
- 40, 40A, 40B: Drain region
- 50, 50A, 50B: Channel region
- 60: Gate oxidation film
- 70, 70A, 70B: Gate electrode
- 80, 80A, 80B: Source electrode
- 90, 90A, 90B: Drain electrode
- 95: Wiring
- 100: Fin portion

## Claims

1. A SiC p-channel MOSFET comprising:
a SiC substrate whose surface plane orientation is (0001); and
a fin portion protruding perpendicularly to a surface of the SiC substrate and made of SiC,
wherein the fin portion has a source region, a drain region, and a channel region sandwiched between the source region and the drain region,
a gate electrode is formed through a gate oxidation film over side and upper surfaces of the channel region, and
the side surface of the channel region is a (1-100) plane.

2. The SiC p-channel MOSFET of claim 1, wherein
a field oxidation film is formed on the surface of the SiC substrate, and
the fin portion is formed so as to penetrate the field oxidation film from the SiC substrate.

3. The SiC p-channel MOSFET of claim 1, wherein
a direction of current flowing through the channel region is perpendicular to a c-axis <0001> direction of the SiC substrate.

4. The SiC p-channel MOSFET of claim 1, wherein
the SiC substrate has an orientation flat indicating a <1-100> direction, and
the fin portion extends in a direction parallel with the orientation flat or a direction crossing the orientation flat at an angle of 60 degrees.

5. A SiC complementary MOS device comprising:
a SiC p-channel MOSFET; and
a SiC n-channel MOSFET,
wherein the SiC p-channel MOSFET and the SiC n-channel MOSFET are formed on a SiC substrate whose surface plane orientation is (0001),
the SiC p-channel MOSFET has a structure identical to that of the SiC p-channel MOSFET of claim 1,
the SiC n-channel MOSFET has a structure identical to that of the SiC p-channel MOSFET, and
the side surfaces of the channel regions of the SiC p-channel MOSFET and the SiC n-channel MOSFET are a (1-100) plane.
